**Europäisches Patentamt**

**European Patent Office**

**Office européen des brevets**

(19)

(11) Veröffentlichungsnummer : **0 328 888 B1**

(12)

# EUROPÄISCHE PATENTSCHRIFT

(45) Veröffentlichungstag der Patentschrift :
**20.05.92 Patentblatt 92/21**

(21) Anmeldenummer : **89100809.6**

(22) Anmeldetag : **18.01.89**

(51) Int. Cl.$^5$ : **C23C 16/44,** C30B 25/14,
C03B 37/025

(54) **Thermostatisierte Anordnung zur sicheren und kontrollierten Verdampfung von giftigen oder an der Luft hochreaktiven flüssigenReaktionsmedien, vorzugsweise für Niederdruckdampfabscheideanlagen in der Halbleitertechnik.**

(30) Priorität : **11.02.88 DE 3804249**

(43) Veröffentlichungstag der Anmeldung :
**23.08.89 Patentblatt 89/34**

(45) Bekanntmachung des Hinweises auf die
Patenterteilung :
**20.05.92 Patentblatt 92/21**

(84) Benannte Vertragsstaaten :
**AT BE CH DE FR GB IT LI NL SE**

(56) Entgegenhaltungen :
**EP-A- 0 113 518
EP-A- 0 151 200
EP-A- 0 194 501
EP-A- 0 210 476
DE-A- 1 644 008**

(56) Entgegenhaltungen :
**DE-A- 3 136 895
DE-A- 3 404 119
US-A- 4 393 013
PATENT ABSTRACTS OF JAPAN, Band 10, Nr.
71 (C-334)[2128], 20. März 1986; & JP-A-60 212
215 (SUMITOMO DENKI KOGYO K.K.)24-
10-1985**

(73) Patentinhaber : **SIEMENS
AKTIENGESELLSCHAFT
Wittelsbacherplatz 2
W-8000 München 2 (DE)**

(72) Erfinder : **Treichel, Helmuth
Weldishofer Strasse 4
W-8900 Augsburg (DE)**
Erfinder : **Fuchs, Dieter
Bunzlauerpl. 1
W-8000 München 50 (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine thermostatisierte Anordnung zur sicheren und kontrollierten Verdampfung von giftigen oder an der Luft hochreaktiven flüssigen Reaktionsmedien, wie sie insbesondere in Niederdruckdampfabscheideanlagen (= LPCVD-Anlagen) bei der Herstellung von für die Halbleitertechnik erforderlichen dotierten und undotierten Isolations- und Kontaktmetallschichten oder für Ätzprozesse verwendet werden, bestehend aus einem mit Deckel versehenem Gehäuse mit im Deckel angeordneter Gaszuführung und Gasableitung für das Trägergas, einem Ventil zur Einstellung der Gasdurchleitungen und einer Durchführung für die Temperaturanzeige.

Solche thermostatisierten Verdampfer-Anordnungen für flüssige Reaktionsmedien, sogenannte Bubbler, sind von verschiedenen Firmen (Firma I. C. Schuhmacher, USA, Firma Olin Hunt, USA), angeboten worden und im Handel erhältlich. Dazu wird beispielsweise auf Prospekte der Firma Olin Hunt Specialty Products Incorporation, Apache Chemical, Seward, Illinois 61077, USA, hingewiesen.

Diese Verdampfer werden verwendet in sogenannten LPCVD-Anlagen (= low pressure chemical vapor deposition) in Halbleiterfertigungen und spielen eine große Rolle bei der Herstellung von Schichten aller Art, bei denen es auf besonders hohe Reinheit, Homogenität und kontrollierte Dotierung ankommt.

Eine LPCVD-Anlage mit der Schichtabscheideverfahren durchgeführt werden können, ist beispielsweise aus der europäischen Patentanmeldung 0 204 182 bekannt. Ein weiteres Verfahren dieser Art ist in der europäischen Patentanmeldung mit dem Aktenzeichen EP-A-271072, vorgeschlagen worden. Dabei handelt es sich um die Herstellung undotierter $SiO_2$-Schichten aus Tetraethylorthosilikat (TEOS), arsendotierte $SiO_2$-Schichten aus Triethylarsenit bzw. Triethylarsenat mit Tetraethylorthosilikat, bor- und phosphordotierte $SiO_2$-Schichten aus Trimethylborat und Trimethylphosphat bzw. -phosphin und Tetraethylorthosilikat oder reine bordotierte $SiO_2$-Schichten oder reine phosphordotierte $SiO_2$-Schichten. Außerdem lassen sich mit diesen Anlagen auch in-situ-Ätzungen mit Trichlorethan oder Phosphorbelegungen mit Phosphoroxychlorid realisieren.

Die bekannten und im Handel erhältlichen Verdampferanordnungen sind problematisch, weil bislang eine kontrollierte und sichere Verdampfung der flüssigen Reaktionsmedien bei gleichzeitiger Kenntnis der Füllmenge der Verdampfergefäße nicht möglich ist.

Bislang werden in den LPCVD-Anlagen Verdampfergefäße aus Quarz verwendet. Diese Quarzgefäße können mittels Lichtschranken bezüglich ihres Füllstandes kontrolliert werden, weisen aber folgende Nachteile auf:

1. Die Behälter müssen zum Befüllen aus den LPGVD-Anlagen ausgebaut werden; dadurch entsteht Gefahr von Bruch, Vergiftung und Kontamination.

2. Ventile und Verschraubungen können nicht aus Edelstahl bestehen. Aus diesem Grunde ist eine Vakuumdichtigkeit nicht 100 %ig gewährleistet, da die Ventile mit Edelstahlverschraubungen in der LPCVD-Anlage verbunden werden müssen.

3. Die Behälter haben kein zusätzliches Füllventil. Bekanntlich ist der Befüllvorgang eine große Gefahrenquelle.

4. Die Behälter haben gleichgroße Ventile für Trägergaseinlaß und -auslaß zur LPCVD-Anlage; dadurch sind Verwechslungen möglich; außerdem ist das Absaugen des gesamten Gefäßinhaltes möglich.

Hochgiftige Substanzen wie Triethylarsenit und Triethylarsenat werden bisher aus Edelstahlverdampfergefäßen in die Anlagen eingebracht, für die die Beheizungs- und Thermostatisiereinheit modifiziert werden muß. Edelstahlbehälter können aber nicht auf einfache Weise wie zum Beispiel Quarzbehälter mit Lichtschranken auf ihren Füllstand überprüft werden. Die Überprüfung des Füllstandes erfolgt bei Edelstahlgefäßen durch:

1. Ausbauen des Verdampfersystems aus der LPCVD-Anlage und Differenzwägung. Das erfordert einen hohen Zeitaufwand.

2. Mechanische Füllstandsmessung (zum Beispiel durch Schwimmer). Dadurch ist die Möglichkeit gegeben, daß Partikelabrieb und Kontamination des Reaktionsmediums auftritt.

3. Kapazitive Füllstandsmessung. Bei dieser Messung können elektrische Einflüsse zum Beispiel durch Zersetzung des Reaktionsmediums durch Stromfluß nicht ausgeschlossen werden.

4. Gammastrahlermethode. Hier droht Gefahr durch austretende Strahlung.

5. Füllstandsmessung mittels Lichtleiter. Es ist möglich, daß eine Belegung der Grenzflächen mit Substanz veränderte Reflexion und damit Fehlmessungen ergeben.

Handelsübliche Edelstahlgefäße haben zudem kein zusätzliches Befüllventil. Wie schon angedeutet, stellt der Befüllvorgang eine Gefahrenquelle dar. Handelsübliche Edelstahlgefäße haben auch keine unterschiedlichen Ventilgrößen. Dadurch sind Verwechslungen möglich und ein Absaugen des gesamten Gefäßinhaltes.

Die Aufgabe, die der Erfindung zugrundeliegt, besteht nun darin, eine Verdampferanordnung anzugeben, die die eben aufgeführten Mängel nicht aufweist. Außerdem soll eine Erhöhung der Prozeßsicherheit durch Kenntnis der Restmenge des Reaktionsmediums gegeben sein. Die Gefahr eines Austritts von flüssigen Reaktionsmedien bei Behälter- oder Ventilbruch sowie beim Ein- oder Ausbau des Verdampfersystems aus der Anlage für Wartungs - oder Reinigungsarbeiten soll minimiert werden.

Diese Aufgabe wird durch eine Anordnung der eingangs genannten Art gelöst, die erfindungsgemäß gekennzeichnet ist durch einen Deckel mit Durchführungen für

a) ein absperrbares Trägergaseinlaßventil,

b) ein absperrbares Trägergasauslaßventil mit zumTrägergaseinlaßventil unterschiedlicher Normgröße,

c) ein Ventil oder ein Befüllstutzen für das Befüllen der Anordnung,

d) einen Temperaturfühler,

e) mit einem im Deckel integrierten Meßsystem zur Anzeige der Mindestfüllstandshöhe.

Weitere Ausgestaltungen der Erfindung ergeben sich aus den Unteransprüchen.

Die Vorteile der erfindungsgemäßen Anordnung gegenüber den handelsüblichen Verdampfern sind folgende:

1. Dadurch, daß Trägergaseinlaß- und -auslaßventil zur LPCVD-Anlage absperrbar ausgebildet sind, ist ein leichter Ein- und Ausbau ohne Belüftung des Verdampfergefäßes und eine erleichterte Dichtigkeitsprüfung gegeben.

2. Da Trägergaseinlaß- und -auslaßventil zur LPCVD-Anlage in unterschiedlichen Normgrößen ausgefertigt sind, ist die Verwechslungsgefahr aufgehoben.

3. Das zusätzliche Befüllventil (absperrbar) für Verdampfergefäße von ungiftigen Substanzen oder der zusätzliche Befüllstutzen für Verdampfergefäße von giftigen Substanzen (externe Befüllung erfolgt durch Fremdfirma) gewährleistet ein Füllen des Verdampfergefäßes ohne längeren Stillstand der LPCVD-Anlage bzw. ohne Gefährdung von Mitarbeitern. Mit Befüllventil beträgt die Befüllzeit weniger als 5 Minuten.

4. Die Anzeige der Mindestfüllstandshöhe durch das in den Verdampferbehälterdeckel integrierte Meßsystem (Schwingquarzsystem; Länge je nach Mindestfüllstand variabel) schließt eine Kontaminationsgefahr des Reaktionsmediums durch Abrieb eines mechanisches Füllstandsmesser aus. Die zu verdampfende Flüssigkeit wird nicht durch elektrische Einflüsse oder durch Strahlung in ihrer Konsistenz oder ihren Eigenschaften verändert. Außerdem ist eine zusätzliche Prozeßsicherheit dadurch gegeben, daß das Meßsystem mit vorgegebener Mindestfüllstandshöhe optischen oder akustischen Alarm bei Unterschreiten der Mindestfüllstandshöhe anzeigt.

5. Der Behälterdeckel ist abnehmbar, zum Beispiel O-Ring-gedichtet, ausgebildet. Der Vorteil ist, bei ungiftigen Substanzen läßt sich das Verdampfergefäß leicht entleeren bzw. säubern.

6. Durch die Ausführung des gesamten Verdampfergefäßes in Edelstahl ist die Bruchgefahr und damit Austreten korrosiver bzw. giftiger Substanzen oder deren Dämpfe bzw. Zersetzungsprodukte minimiert. Ein Lecktest der Anlage ist bis hin zum Verdampfergefäß möglich. Außerdem ist zusätzliche Prozeßsicherheit für die Prozeßführung und die Prozeßbetreuer gewährleistet.

7. Die Ausfertigungs ist kostengünstiger als die kommerziell verfügbaren Verdampfersysteme.

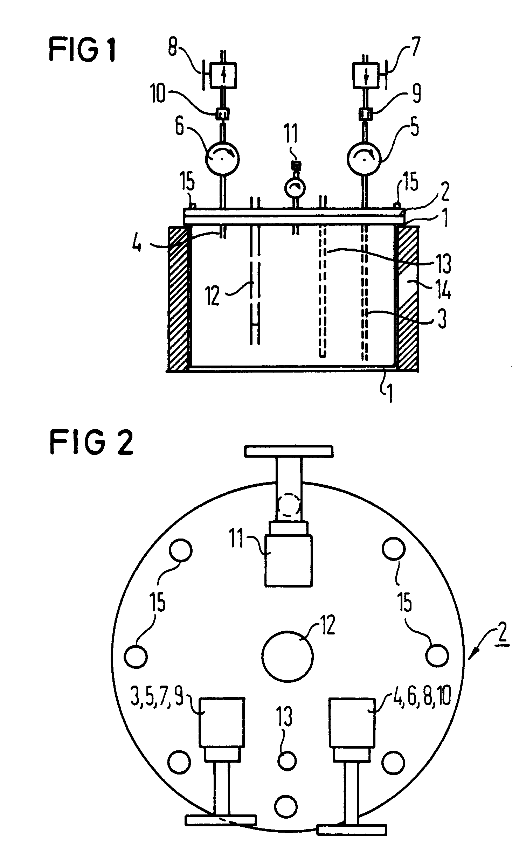

Weitere Einzelheiten der Erfindung werden nachfolgend anhand eines Ausführungsbeispiels und der Figuren 1 und 2 noch näher erläutert. Dabei zeigt

die Figur 1 in schematischer Darstellung die Vordersicht einer erfindungsgemäßen Verdampferanordnung (Gehäuse bzw. Gefäß mit Deckel) und die Figur 2 den Gehäusedeckel in Draufsicht.

Figur 1: Die aus Gehäuse 1 und Deckel 2 bestehende Verdampferanordnung aus Edelstahl wird bei der Verdampfung nichttoxischer Substanzen wie Tetraethylorthosilikat zur Befüllung im Unterdruck belassen. Das Einlaßventil 5 mit dem Einleitungsrohr 3 für das Trägergas, das Auslaßventil 6 zur LPCVD-Anlage (nicht dargestellt) mit dem Gasauslaßrohr 4, das Absperrventil 7 zum Trägergas und das Absperrventil 8 zum Reaktor werden geschlossen. Mittels eines flexiblen Schlauches wird von einem Vorratsbehälter (in der Figur nicht dargestellt) das flüssige Reaktionsmedium über das geöffnete Befüllventil 11 durch den im Gehäuse 1 herrschenden Unterdruck eingesaugt. Nach dem Füllen wird das Befüllventil 11 geschlossen und nach Entfernen des Befüllschlauches über eine Dichtung eine Blindkappe aufgesetzt (nicht dargestellt). Nun werden Einlaßventil 5, Auslaßventil 6 und die Absperrventile 7 und 8 zum Reaktor (LPCVD-Anlage) geöffnet und die Anordnung ist einsatzbereit. Die Befüllzeit beträgt weniger als 10 Minuten.

Bei Verwendung stark toxischer Substanzen wie Triethylarsenit oder Triethylarsenat müssen beim Befüllen die Bubbler (1, 2) aus sicherheitstechnischen Gründen ausgebaut und an den Hersteller der Substanzen versandt werden. Die drei Ventile: Einlaßventil 5, Auslaßventil 6 und Befüllstutzen 11 werden dann für den Versand mit Blindkappen versehen (nicht dargestellt). Ausbau und Wiedereinbau in die Anlage erfolgt in bekannter Weise. Mit den Bezugszeichen 9 und 10 sind Verschraubungen in den Gasleitungen bezeichnet zum leichteren Wechseln und für die Wartung der Anordnung. Mit dem Bezugszeichen 12 ist die Füllstandsanzeige, die mit Einschraubgewinde eingeführt wird, mit 13 der Temperaturfühler, der über ein Rohr eingeführt wird, und mit 14 die Heizung des Bubbler bezeichnet. Die geraden Pfeile zeigen die Durchflußrichtung des Trägergases an, die Drehpfeile die Schließrichtung der Ventile.

Figur 2 zeigt die Anordnung der einzelnen Funktionsteile und

Meßeinrichtung im Deckel zueinander. Es gelten die gleichen Bezugzeichen wie in Figur 1. Mit dem Bezugzeichen 15 sind die Schrauben angedeutet, die das Verschrauben des Deckels (2) mit dem Gehäuseteil (1) bewirken.

**Patentansprüche**

1. Thermostatisierte Anordnung zur sicheren und kontrollierten Verdampfung von giftigen oder an der Luft hochreaktiven flüssigen Reaktionsmedien, wie sie insbesondere in Niederdruckdampfabscheideanlagen (= LPCVD-Anlagen) bei der Herstellung von für die Halbleitertechnik erforderlichen dotierten und undotierten Isolations- und Kontaktmetallschichten oder für Ätzprozesse verwendet werden, bestehend aus einem mit Deckel versehenem Gehäuse mit im Deckel angeordneter Gaszuführung und Gasableitung für das Trägergas, einem Ventil zur Einstellung der Gasdurchleitung und einer Durchführung für die Temperaturanzeige, **gekennzeichnet durch** einen Deckel (2) mit Durchführungen für

a) ein absperrbares Trägergaseinlaßventil (5, 7),

b) ein absperrbares Trägergasauslaßventil mit zum Trägergaseinlaßventil (5, 7) unterschiedlicher Normgröße (6, 8),

c) ein Ventil oder einen Befüllstutzen (11) für das Befüllen der Anordnung (1),

d) einen Temperaturfühler (13) und

e) mit einem im Deckel (2) integrierten Meßsystem (12) zur Anzeige der Mindestfüllstandshöhe.

2. Anordnung nach Anspruch 1, **dadurch gekennzeichnet,** daß der Deckel (2) abnehmbar, vorzugsweise mit O-Ring gedichtet ist (15).

3. Anordnung nach Anspruch 1 oder 2, **dadurch gekennzeichnet,** daß zwischen den Einlaß- (5) bzw. Auslaß- (6) und den Absperr-Ventilen (7, 8) für das Trägergas Verschraubungen (9, 10) in den Trägergasleitungen vorgesehen sind.

4. Anordnung nach einem der Ansprüche 1 bis 3, **dadurch gekennzeichnet,** daß das Befüllventil (11) absperrbar ausgebildet ist.

5. Anordnung nach einem der Ansprüche 1 bis 4, **dadurch gekennzeichnet,** daß zusätzlich ein Befüllstutzen für eine externe Befüllung von giftigen Substanzen vorgesehen ist.

6. Anordnung nach einem der Ansprüche 1 bis 5, **dadurch gekennzeichnet,** daß als Meßsystem (12) für die Mindestfüllstandshöhe ein in bezug auf seine Länge dem Mindestfüllstand angepaßtes Schwingquarzsystem angebracht ist.

7. Anordnung nach Anspruch 6, **dadurch gekennzeichnet,** daß Mittel vorgesehen sind, durch welche bei Unterschreiten der Mindestfüllstandshöhe optischer oder akustischer Alarm gegeben wird.

8. Anordnung nach einem der Ansprüche 1 bis 7, **dadurch gekennzeichnet,** daß Deckel (2) und Gehäuse (1) sowie Durchführungen (3, 4), Ventile (5, 6, 7, 8, 11) und Verschraubungen (9, 10, 15) überwiegend aus Edelstahl bestehen.

**Claims**

1. A thermostat-controlled device for the safe and controlled vaporization of toxic liquid reaction media or of reaction media which are highly reactive in air such as those used, in particular, in low-pressure vapour deposition systems (= LPCVD systems) in the production of doped and undoped insulation and contact metal layers required for semiconductor technology or for etching processes, comprising a housing provided with a lid with gas inlet and gas outlet in the lid for the carrier gas, a valve for adjusting the gas passage and a leadthrough for the temperature indication, characterised by a lid (2) with leadthroughs for

a) a closeable carrier gas inlet valve (5, 7),

b) a closeable carrier gas outlet valve (6, 8) with a different standard size from the carrier gas inlet valve (5, 7),

c) a valve or filling nozzle (11) for filling the device (1),

d) a temperature sensor (13), and

e) a measuring system (12) integrated in the lid (2) for indicating the minimum filling level.

2. Device according to Claim 1, characterised in that the lid (2) is detachably sealed, preferably with an O-ring (15).

3. Device according to Claim 1 or 2, characterised in that screw joints (9, 10) are provided in the carrier gas lines between the inlet valve (5) or outlet valve (6) and the shut-off valves (7, 8) for the carrier gas.

4. Device according to one of Claims 1 to 3, characterised in that the filling valve (11) is of closeable design.

5. Device according to one of Claims 1 to 4, characterised in that a filling nozzle is additionally provided for an external filling of toxic substances.

6. Device according to one of Claims 1 to 5, characterised in that an auxiliary quartz system which is matched in terms of its length to the minimum filling level is installed as measuring system (12) for the minimum filling level.

7. Device according to Claim 6, characterised in that means are provided which provide an optical or acoustic alarm if the filling level falls below the minimum.

8. Device according to one of Claims 1 to 7, characterised in that lid (2) and housing (1), and lead-throughs (3, 4), valves (5, 6, 7, 8, 11) and screw joints (9, 10, 15) are predominantly composed of stainless steel.


**Revendications**

1. Dispositif thermostaté pour réaliser l'évaporation sûre et contrôlée de milieux réactifs liquides toxiques ou très réactifs à l'air, du type utilisé notamment dans des installations de dépôt en phase vapeur à basse pression (= installations LPCVD) lors de la réalisation de couches isolantes et de couches métalliques de contact dopées et non dopées, nécessaires pour la technique des semiconducteurs, ou pour des processus de corrosion, ce dispositif étant constitué par un boîtier pourvu d'un couvercle dans lequel sont ménagés un conduit d'amenée et un conduit d'évacuation pour le gaz porteur, et une vanne pour le réglage du passage du gaz et un passage pour l'affichage de la température, caractérisé par un couvercle (2) comportant des traversées pour
a) une vanne blocable (5,7) d'admission du gaz porteur,
b) une vanne blocable de sortie du gaz porteur possédant un diamètre normalisé (6,8) différent de celui de la vanne (5,7) d'admission du gaz porteur,
c) une vanne ou une tubulure de remplissage (11) pour le remplissage du dispositif (1),
d) un capteur de température (13), et
e) un système de mesure (12), intégré dans le couvercle (2), pour l'affichage de la hauteur minimale du niveau de remplissage.

2. Dispositif suivant la revendication 1, caractérisé par le fait que le couvercle (2) est amovible, en étant étanchéifié de préférence par un joint torique (15).

3. Dispositif suivant la revendication 1 ou 2, caractérisé par le fait que des systèmes à vis (9,10) sont prévus dans les canalisations véhiculant le gaz porteur entre la vanne d'admission (5) et la vanne de sortie (6) et les vannes de coupure (7,8) pour le gaz porteur.

4. Dispositif suivant l'une des revendications 1 à 3, caractérisé par le fait que la vanne de remplissage (11) est agencée de manière à pouvoir être bloquée.

5. Dispositif suivant l'une des revendications 1 à 4, caractérisé par le fait qu'il est en outre prévu une tubulure de remplissage pour réaliser un remplissage extérieur avec des substances toxiques.

6. Dispositif suivant l'une des revendications 1 à 5, caractérisé par le fait qu'un système à quartz oscillant, dont la longueur est adaptée au niveau de remplissage minimum, est monté en tant que système (12) de mesure de la hauteur du niveau de remplissage minimum.

7. Dispositif suivant la revendication 6, caractérisé par le fait qu'il est prévu des moyens, grâce auxquels une alarme optique ou acoustique est délivrée lorsque le niveau de remplissage tombe au-dessous de la hauteur minimale.

8. Dispositif suivant l'une des revendications 1 à 7, caractérisé par le fait que le couvercle (2) et le boîtier (1) ainsi que des traversées (3,4), des vannes (5,6,7,8,11) et des dispositifs à vis (9,10,15) sont réalisées de façon prépondérante en un acier traité.

FIG 1

FIG 2